# FASCICULE DE BREVET EUROPEEN

(11) **EP 3 763 007 B1**
(45) Date de publication et mention de la délivrance du brevet: **04.05.2022**
(21) Numéro de dépôt: 19715156.6
(22) Date de dépôt: 06.03.2019
(51) Int. Cl.: H01S 5/183, H01S 5/20

(54) **DISPOSITIF D'EMISSION LUMINEUSE COMPORTANT AU MOINS UN VCSEL ET UNE LENTILLE DE DIFFUSION**
LICHTEMISSIONSVORRICHTUNG MIT MINDESTENS EINEM VCSEL UND EINER STREULINSE
LIGHT EMISSION DEVICE COMPRISING AT LEAST ONE VCSEL AND A SPREAD LENS

(30) Priorité: 08.03.2018 FR 1851995
(43) Date de publication de la demande: 13.01.2021
(73) Titulaire: COMMISSARIAT À L'ÉNERGIE ATOMIQUE ET AUX ÉNERGIES ALTERNATIVES, 75015 Paris (FR)
(72) Inventeur: SCIANCALEPORE, Corrado, 38054 GRENOBLE Cedex 9 (FR)
(74) Mandataire: INNOV-GROUP
(86) Numéro de dépôt international: PCT/FR2019/050501
(87) Numéro de publication internationale: WO 2019/171003

(56) Documents cités:
- US-A- 5 426 657
- US-A- 5 940 422
- US-A1- 2002 085 610
- US-A1- 2005 089 075
- US-A1- 2007 230 529

## Description

### DOMAINE TECHNIQUE

Le domaine de l'invention est celui des dispositifs d'émission lumineuse comportant au moins une source laser à cavité verticale émettant par la surface (VCSEL), laquelle peut être adaptée à émettre un rayonnement lumineux avec une puissance optique élevée dans le domaine du visible ou du proche infrarouge, par exemple autour de 900nm. Un tel dispositif d'émission peut trouver une application dans l'éclairage d'une scène ou la télédétection par laser (LiDAR), entre autres, notamment pour le domaine automobile ou celui de la téléphonie portable, voire celui de la réalité virtuelle/augmentée.

### ÉTAT DE LA TECHNIQUE ANTÉRIEURE

Les dispositifs d'émission lumineuse à base de VCSEL peuvent comporter au moins une source laser VCSEL associée à une lentille de diffusion adaptée à mettre en forme le faisceau lumineux généré par le VCSEL selon un diagramme d'émission désiré. C'est le cas notamment des scanners tridimensionnels, entre autres, qui peuvent comporter une matrice de VCSEL dont chaque VCSEL est associé à une microlentille de type plan-convexe réalisée en polymère, les microlentilles pouvant être assemblées à la matrice de VCSEL via une étape de report (*pick and place*, en anglais) des microlentilles, les unes après les autres, sur les VCSEL.

Cependant, un procédé de fabrication des tels dispositifs d'émission lumineuse nécessite notamment de pouvoir contrôler précisément les six axes d'ajustement de la position relative de chaque microlentille vis-à-vis du VCSEL correspondant, les défauts de positionnement étant susceptibles de dégrader le diagramme d'émission.

La publication de Moench et al. intitulée VCSEL based sensors for distance and velocity, 2016, Proc. of SPIE, Vol.9766, 97660A, décrit un exemple de dispositif d'émission lumineuse comportant une matrice de VCSEL à laquelle est fixée une matrice de microlentilles de type plan-convexe réalisée d'un seul tenant à partir d'une même couche de polymère (procédé du type *wafer-level*). Ainsi, un tel procédé de fabrication présente de meilleures performances dans la mesure où les microlentilles sont fixées au moyen d'une seule étape de report. Les risques de défaut de positionnement des microlentilles sont alors réduits.

D'autres exemples de VCSEL sont divulgués dans US 2002/085610 A1 (MORGAN), US 5 426 657 A (VAKHSHOORI) et US 2007/230529 A1 (MOCHIZUKI).

Cependant, il existe un besoin de disposer d'un dispositif d'émission lumineuse comportant au moins un VCSEL associé à une lentille de diffusion, le VCSEL pouvant émettre un faisceau lumineux avec une puissance optique élevée, dont le procédé de fabrication présente encore de meilleures performances notamment en termes de simplicité, de coût et/ou de précision de positionnement de la lentille de diffusion, pour obtenir le diagramme d'émission voulu.

### EXPOSÉ DE L'INVENTION

L'invention a pour objectif de remédier au moins en partie aux inconvénients de l'art antérieur, et plus particulièrement de proposer un dispositif d'émission lumineuse qui comporte une source laser VCSEL associée à une lentille de diffusion, le VCSEL étant susceptible de fournir une puissance optique élevée, dont le procédé de fabrication peut présenter de performances élevées.

Un but de l'invention est également de proposer un dispositif d'émission lumineuse dont la source laser VCSEL est adaptée à pouvoir fournir une puissance optique élevée, et dont la lentille de diffusion est adaptée à transmettre le faisceau lumineux généré par le VCSEL selon un diagramme d'émission désiré, dont la répartition angulaire de l'intensité lumineuse est sensiblement homogène, et éventuellement à symétrie de révolution. Le faisceau lumineux émis par le dispositif d'émission peut alors présenter un astigmatisme faible voire nul.

Pour cela, l'objet de l'invention est un dispositif d'émission lumineuse d'un faisceau lumineux, comprenant une source laser à cavité verticale émettant par la surface, comportant une cavité résonante, s'étendant suivant un axe optique principal, délimitée par deux miroirs, dont un miroir supérieur qui définit une surface d'émission, la cavité résonante étant adaptée à supporter plusieurs modes optiques transverses, dont un mode transverse fondamental et des modes transverses d'ordre supérieur présentant une symétrie de rotation d'ordre deux autour de l'axe optique principal.

Selon l'invention, le dispositif d'émission comporte en outre un réseau à contraste d'indice, formant une lentille de diffusion, disposé sur la surface d'émission, et comportant une pluralité de plots distincts les uns des autres et réalisés en au moins un matériau d'un premier indice de réfraction entourés par un milieu d'un deuxième indice de réfraction différent du premier indice, parmi lesquels :
- un plot central, centré sur l'axe optique principal, et
- plusieurs plots périphériques, disposés périodiquement le long d'une ou plusieurs lignes concentriques vis-à-vis du plot central, et agencés de sorte que le réseau présente, vis-à-vis de l'axe optique principal, une symétrie de rotation d'ordre impair supérieur ou égal à trois.

Certains aspects préférés mais non limitatifs de ce dispositif d'émission lumineuse sont les suivants.

Pour une ligne concentrique dite de rang 1 disposée en regard du plot central, une période radiale peut être définie comme étant une distance suivant un axe radial entre une bordure radiale externe d'un plot périphérique vis-à-vis d'une bordure radiale du plot central. Une période azimutale peut être définie comme étant la période de l'agencement périodique des plots périphériques suivant ladite ligne concentrique de rang 1. La période radiale et la période azimutale peuvent être supérieures ou égales à λₑ/n_{eff'}, où λₑ est la longueur d'onde du faisceau lumineux généré par la source laser, et n_{eff'} est un indice effectif d'un mode longitudinal de longueur d'onde λₑ et guidé par le réseau.

Le dispositif d'émission peut comporter une ligne concentrique dite de rang 2 disposée de manière à entourer la ligne concentrique de rang 1. Les lignes concentriques de rang 1 et de rang 2 sont alors distinctes l'une de l'autre. Une période radiale peut être définie comme étant une distance suivant un axe radial entre une bordure radiale externe d'un plot périphérique de la ligne concentrique de rang 2 vis-à-vis d'une bordure radiale externe d'un plot périphérique de la ligne concentrique de rang 1. Une période azimutale peut être définie comme étant la période de l'agencement périodique des plots périphériques suivant ladite ligne concentrique de rang 2. Les périodes radiale et azimutale associées à la ligne concentrique de rang 2 peuvent être respectivement supérieures ou égales aux périodes radiale et azimutale associées à la ligne concentrique de rang 1.

Les périodes radiale et azimutale associées à une ligne concentrique de rang i peuvent être supérieures ou égales à la longueur d'onde λₑ.

Le réseau peut comporter au moins deux lignes concentriques dites de rang 1 et 2, distinctes l'une de l'autre, les plots périphériques de la ligne concentrique de rang 2 étant agencés de manière à présenter un décalage azimutal avec les plots périphériques de la ligne concentrique de rang 1.

Les plots périphériques de la ligne concentrique de rang 2 peuvent être agencés en opposition de phase avec les plots périphériques de la ligne concentrique de rang 1.

La cavité résonante peut comporter un diaphragme définissant une ouverture optique dont une dimension latérale est supérieure ou égale à la longueur d'onde λₑ du faisceau lumineux généré par la source laser.

Le plot central peut présenter une dimension latérale supérieure ou égale à la moitié, à 10% près, d'une dimension latérale de l'ouverture optique.

Le plot central et l'ouverture optique peuvent présenter une forme circulaire. La source laser peut présenter une forme de mesa dont une section droite est circulaire.

Le contraste d'indice entre le premier indice de réfraction et le deuxième indice de réfraction peut être inférieur ou égal à 1.

Les plots peuvent présenter une épaisseur égale à un multiple impair de λₑ/(4.n_{H}), où λₑ est la longueur d'onde du faisceau lumineux généré par la source laser et n_{H} est l'indice de réfraction des plots. Le réseau à contraste d'indice présente avantageusement une épaisseur locale égale à un multiple impair de λₑ/(4.n_{H}). Aussi, la réflectivité du miroir supérieur n'est sensiblement pas modifiée par la présence du réseau à contraste d'indice. Le réseau n'influe donc pas ou peu sur les modes transverses présents dans la cavité optique.

L'invention porte également sur un procédé de fabrication du dispositif d'émission selon l'une quelconque des caractéristiques précédentes, le procédé comportant une étape de réalisation collective d'une matrice de sources laser identiques entre elles, une étape de dépôt conforme d'une couche de passivation sur la surface d'émission des sources laser, puis une étape de réalisation collective des réseaux à contraste d'indice par gravure localisée de la couche de passivation.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1 est une vue schématique et partielle, en coupe transversale, d'un dispositif d'émission lumineuse selon un mode de réalisation comportant une source laser VCSEL et un réseau à contraste d'indice formant une lentille planaire de diffusion ;
la figure 2A est une vue schématique, en coupe transversale, d'une partie du dispositif d'émission représenté sur la fig.1, illustrant au niveau de l'ouverture optique un mode transverse fondamental et un mode transverse d'ordre supérieur, et la figure 2B illustre la répartition spatiale de l'intensité lumineuse des modes transverses supportés par la cavité résonante de la source laser VCSEL ;
les figures 3A et 3B sont des vues de dessus, schématiques, d'un réseau à contraste d'indice formant la lentille planaire de diffusion du dispositif d'émission selon un mode de réalisation, la fig.3B étant une vue partielle du réseau illustré sur la fig.3A ;
et la figure 3C est une vue de dessus, schématique, d'une variante du réseau à contraste d'indice.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près. Par ailleurs, l'expression « comportant un » doit être comprise comme « comportant au moins un », sauf indication contraire.

L'invention porte d'une manière générale sur un dispositif d'émission de lumière comportant une source laser à cavité verticale émettant par la surface (VCSEL, pour *Vertical-Cavity Surface-Emitting Laser*, en anglais) et une lentille planaire de diffusion assurant la mise en forme du faisceau lumineux généré par la source laser VCSEL selon un diagramme d'émission prédéterminé. On utilisera l'acronyme VCSEL dans la suite de la description.

Le VCSEL est adapté à pouvoir fournir une puissance optique élevée. Comme il sera détaillé par la suite, cela se traduit par le fait que sa cavité résonante supporte plusieurs modes optiques transverses, c'est-à-dire supporte le mode transverse fondamental ainsi que des modes transverses d'ordre supérieur.

La lentille de diffusion est dite planaire dans le sens où elle est formée par un réseau à contraste d'indice. Le réseau est dimensionné de manière à obtenir le diagramme d'émission voulu du faisceau lumineux émis par le dispositif d'émission. Plus précisément, le diagramme d'émission présente une symétrie de révolution sensiblement homogène, au sens où il ne présente pas ou peu d'astigmatisme optique, ceci alors que la cavité résonante est adaptée à supporter plusieurs modes optiques transverses, ces derniers pouvant en outre présenter une polarisation TE (transverse électrique) et/ou TM (transverse magnétique).

La source laser est de préférence adaptée à émettre un faisceau lumineux centré sur une longueur d'onde d'émission λₑ comprise dans le visible ou le proche infrarouge, par exemple autour de 900nm. Par ailleurs, le diagramme d'émission, ou cône de diffusion, représente la répartition angulaire de l'intensité du faisceau lumineux émis par le dispositif d'émission autour d'un axe principal de diffusion.

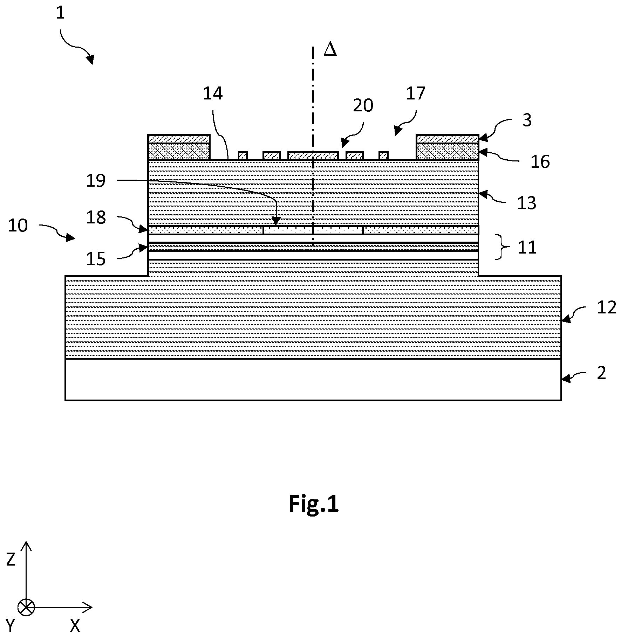

La figure 1 est une vue en coupe transversale, schématique et partielle, d'un dispositif d'émission lumineuse 1 selon un mode de réalisation. Le dispositif d'émission 1 comporte au moins une source laser 10 à cavité verticale émettant par la surface (VCSEL) et un réseau 20 à contraste d'indice formant une lentille planaire de diffusion.

On définit ici et pour la suite de la description un repère direct tridimensionnel orthogonal (X,Y,Z), où les axes X et Y forment un plan parallèle au plan principal du réseau 20 et à la surface d'émission 14 du VCSEL, et où l'axe Z est orienté suivant la direction d'émission lumineuse. Dans la suite de la description, les termes « inférieur » et « supérieur » s'entendent comme étant relatifs à un positionnement croissant suivant la direction +Z.

Le VCSEL 10 comporte une cavité résonante 11 de type Fabry-Pérot délimitée par deux réflecteurs, ici deux miroirs de Bragg 12, 13, et un milieu à gain 15 situé dans la cavité résonante 11. Il est adapté à générer un faisceau lumineux de longueur d'onde d'émission λₑ, celle-ci étant définie au premier ordre par la dimension de la cavité résonante 11 et par l'indice de réfraction du ou des composés semiconducteurs qui la forment. A titre d'exemple, la longueur d'onde d'émission λₑ peut être située dans le visible ou dans le proche infrarouge, par exemple peut être égale à 94onm environ.

Les miroirs de Bragg 12, 13 sont formés d'une alternance de couches semiconductrices quart d'onde ayant respectivement un indice de réfraction élevé et un indice de réfraction faible. Les couches semiconductrices quart d'onde peuvent être réalisées, à titre purement illustratif, à partir des composés semiconducteurs GaAs et AlAs, et de leurs alliages. Ainsi, les couches semiconductrices quart d'onde peuvent être réalisées en GaAs et en AlGaAs. L'indice de réfraction du AlAs est de 2,9 dans le domaine du proche infrarouge et celui du GaAs est de 3,5. Le composé semiconducteur AlₓGa₁₋ₓAs présente ainsi un indice de réfraction compris entre 2,9 et 3,5 en fonction de la teneur x d'aluminium.

Le nombre de couches semiconductrices quart d'onde est suffisant pour obtenir une réflectivité élevée des miroirs de Bragg 12, 13 à la longueur d'onde d'émission λₑ, par exemple de l'ordre de 99,9%. Cette réflectivité est bien plus élevée que dans le cas d'une source laser de type ruban, dans la mesure où, dans un VCSEL 10, le gain du milieu amplificateur 15 est faible puisque le faisceau lumineux le traverse de manière perpendiculaire.

Dans cet exemple, le VCSEL 10 comporte un miroir de Bragg inférieur 12 réalisé en GaAs/AlGaAs et reposant sur un substrat 2 ici réalisé en GaAs ; une cavité résonante 11 réalisée ici en AlGaAs et comportant un milieu à gain 15 formé de plusieurs puits quantiques ici en InGaAs ; et un miroir de Bragg supérieur 13 réalisé en GaAs/AlGaAs. De plus, le substrat 2 et le miroir de Bragg inférieur 12 sont ici dopés selon un premier type de conductivité, par exemple de type n. Le miroir de Bragg supérieur 13 est dopé selon un second type de conductivité opposé au premier type, ici de type p.

Des contacts électriques sont réalisés de manière à permettre la polarisation électrique du VCSEL 10. Ainsi, un contact électrique inférieur (non représenté) peut être déposé en contact ohmique avec le substrat 2, par exemple sur la face inférieure de ce dernier. Un contact électrique supérieur 16 est déposé sur la face supérieure du miroir de Bragg supérieur 13. Chaque contact électrique peut être réalisé en une ou plusieurs couches métalliques, par exemple des couches d'or, et comporter une couche de platine, de titane ou de nickel, pour améliorer l'adhérence du contact électrique sur le miroir de Bragg 13 et/ou former une barrière de diffusion.

Le contact électrique supérieur 16 présente une forme annulaire, par exemple circulaire, sur la face supérieure du miroir de Bragg 13, de manière à autoriser la transmission hors du VCSEL 10 du faisceau lumineux généré dans la cavité résonante 11. La zone de la face supérieure non revêtue par le contact électrique forme ainsi une surface d'émission 14 et définit une ouverture électrique 17 du VCSEL 10.

Dans le but d'abaisser le seuil de courant du VCSEL 10, une couche diélectrique annulaire 18 peut être formée dans la cavité résonante 11, par exemple située entre les puits quantiques et le miroir supérieur 13. La couche diélectrique annulaire 18 est réalisée en un matériau électriquement isolant, par exemple en un oxyde d'aluminium AlOₓ. La zone interne délimitée par la couche diélectrique annulaire 18 définit une ouverture optique 19 du VCSEL 10. La couche diélectrique annulaire 18 permet de concentrer les lignes de courant et ainsi d'augmenter la densité de courant, réduisant ainsi le seuil de fonctionnement du VCSEL 10. Elle forme également un diaphragme 18 ou un guide d'onde assurant un confinement optique par variation de l'indice de réfraction.

La couche diélectrique annulaire 18 peut être formée classiquement par oxydation d'une couche épitaxiée en AlGaAs à forte teneur en aluminium, après gravure des flancs du miroir supérieur 13 et de la cavité résonante 11 pour obtenir la forme en mesa du VCSEL 10 représentée sur la fig.1. La structure ainsi obtenue est alors placée dans un four sous atmosphère oxydante, de sorte que la couche en AlGaAs à forte teneur en aluminium s'oxyde progressivement à partir des flancs de la structure en mesa. Connaissant la vitesse de la réaction d'oxydation humide, celle-ci est stoppée lorsque la couche diélectrique annulaire 18 définit l'ouverture optique 19 voulue.

L'ouverture optique 19 et l'ouverture électrique 17 sont sensiblement coaxiales et centrées sur un axe optique principal Δ du VCSEL 10 suivant lequel le faisceau lumineux généré par le VCSEL 10 est émis. Dans cet exemple, le VCSEL 10 présente une forme en mesa à section circulaire et les ouvertures optique et électrique sont également circulaires. Cependant, le VCSEL 10 peut présenter d'autres formes de section du mesa, par exemple une forme carrée ou plus largement polygonale, centrée sur l'axe optique principal Δ.

De manière alternative, l'ouverture optique 19 peut être définie, non pas par la couche diélectrique annulaire, mais par une zone annulaire formée par implantation ionique localisée d'ions (H+, O+, N+ ou F+) de manière à assurer le confinement optique par guidage par le gain d'une part, ainsi que la courbure des lignes de courant, diminuant le seuil en courant d'autre part.

Comme mentionné précédemment, le VCSEL 10 est adapté à pouvoir fournir une puissance optique élevée, telle que, par exemple, une puissance supérieure ou égale à 4mW. Or, la puissance optique est directement proportionnelle à la taille de l'ouverture optique 19 dans le plan XY. Aussi, l'ouverture optique 19 présente une taille grande devant la longueur d'onde d'émission λₑ, ce qui se traduit par le fait que le VCSEL 10 est alors multimode transversal, comme expliqué par la suite. La cavité résonante 11 du VCSEL 10 est donc adaptée à supporter plusieurs modes optiques transverses.

Rappelons au préalable qu'un VCSEL 10 ne supporte qu'un seul mode optique longitudinal. En effet, son intervalle spectral libre est très supérieur à la largeur de la courbe de gain du milieu amplificateur 15. Par contre, il peut supporter plusieurs modes optiques transverses lorsque, de manière connue, la taille de l'ouverture optique 19 dans le plan XY est grande devant la longueur d'onde d'émission λₑ. A titre d'exemple, pour une longueur d'onde λₑ de 940nm, l'ouverture optique 19 présente une taille supérieure ou égale à 2µm, voire à 2,5µm, et de préférence supérieure ou égale à 4µm, voire à 5µm. Ainsi, les modes optiques supportés dans la cavité résonante 11 comportent une composante parallèle à l'axe de propagation (et donc à l'axe optique principal Δ) et une composante transversale liée au confinement optique assurée ici par l'ouverture optique 19.

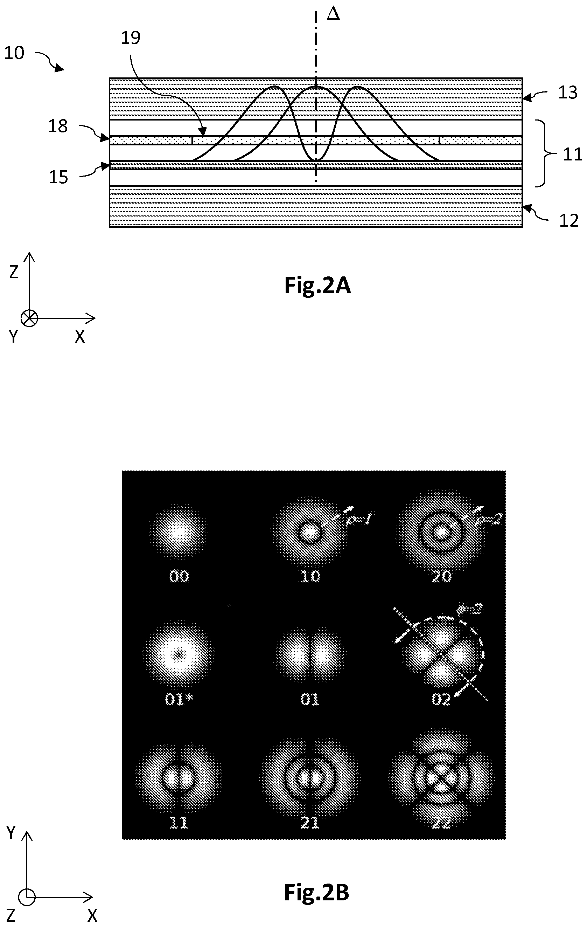

La figure 2A est une vue schématique en coupe transversale d'une partie du VCSEL 10 illustré sur la fig.1. Est représentée la cavité résonante 11 et une partie des miroirs inférieur 12 et supérieur 13. L'ouverture optique 19 est délimitée par le périmètre interne de la couche diélectrique annulaire 18.

Dans la mesure où la taille de l'ouverture optique 19 dans le plan XY (par ex. ici son diamètre) est grande devant la longueur d'onde d'émission λₑ, par exemple est égale à 6µm environ alors que λₑ est égal à 94onm environ, plusieurs modes optiques transverses sont supportés par la cavité résonante 11. Dans cet exemple sont représentés le mode transverse fondamental ainsi qu'un mode transverse d'ordre supérieur.

Par ailleurs, du fait que l'ouverture optique 19 ait une taille, tant suivant l'axe X que l'axe Y, grande par rapport à la longueur d'onde λₑ, notamment ici où l'ouverture optique 19 présente une forme circulaire dont le diamètre est de l'ordre de plusieurs microns, les modes optiques transverses peuvent être polarisés tant en mode TE (transverse électrique) qu'en mode TM (transverse magnétique).

La figure 2B est une vue de dessus du champ optique des différents modes transverses que peut supporter un VCSEL 10 à mesa circulaire tel que celui illustré sur la fig.1. Il apparaît que leur répartition spatiale d'intensité peut être modélisée par les polynômes de Laguerre-Gauss (comme illustré sur la fig.2B) ou d'Hermite-Gauss. Dans la suite de la description, ils sont notés (l,p) en fonction des ordres radial 1 et azimutal p, qui correspondent respectivement au nombre de nœuds d'intensité suivant l'axe radial p et l'axe azimutal φ.

Ainsi, le mode transverse (0,0) est le mode fondamental. Il ne comporte pas de nœuds d'intensité suivant l'axe radial p ni suivant l'axe azimutal φ. Sa répartition spatiale d'intensité est de forme sensiblement gaussienne et présente donc une symétrie sensiblement axiale autour de l'axe optique principal Δ. La puissance optique du faisceau lumineux généré par le VCSEL 10 est portée notamment par le mode transverse fondamental.

Par ailleurs, il apparaît que la puissance optique du faisceau lumineux généré par le VCSEL 10 est également portée, de manière non négligeable, par les modes transverses d'ordre azimutal p égal à 1 : à savoir les modes (0,1), (1,1) et (2,1). Or, comme le montre la fig.2B, ces modes transverses d'ordre p=1 présentent une symétrie de rotation d'ordre 2 autour de l'axe optique principal Δ. Par symétrie de rotation d'ordre n, on entend une symétrie autour de l'axe Δ d'un angle 360°/n. Ainsi, la répartition spatiale d'intensité de chacun des modes transverses (0,1), (1,1) et (2,1) est identique à elle-même après une rotation autour de l'axe optique principal Δ d'un angle 360°/2=180°.

De tels modes transverses peuvent être présents dans un VCSEL 10 dont la cavité résonante 11 présente une section droite, dans un plan XY orthogonal à l'axe optique principal Δ, de forme notamment circulaire, voire polygonale, telle qu'une forme carrée.

Le dispositif d'émission lumineuse 1 présente un diagramme d'émission prédéterminé, c'est-à-dire que l'intensité en champ lointain du faisceau lumineux émis par le dispositif 1 présente une répartition angulaire prédéterminée autour d'un axe principal de diffusion. Cet axe principal de diffusion coïncide sensiblement avec l'axe optique principal Δ du VCSEL 10. Le pic d'intensité est centré sur l'axe principal de diffusion et l'intensité lumineuse à mi-hauteur forme un angle de diffusion non nul prédéterminé.

De plus, le diagramme d'émission présente une répartition angulaire de l'intensité lumineuse sensiblement homogène. Par ailleurs, la répartition angulaire de l'intensité lumineuse peut ne pas présenter de dissymétrie de révolution, moyennant les imperfections d'alignement des ouvertures optique et électrique, ce qui se traduit par un astigmatisme faible voire quasi nul du faisceau lumineux émis. Autrement dit, la distribution angulaire de l'intensité lumineuse présente une symétrie de révolution sensiblement homogène, notamment lorsque le VCSEL est en forme de mesa à section droite circulaire, et que l'ouverture optique est circulaire. Pour cela, le dispositif d'émission 1 comporte une lentille planaire de diffusion 20 adaptée à mettre en forme le faisceau lumineux généré par le VCSEL 10 selon un tel diagramme d'émission.

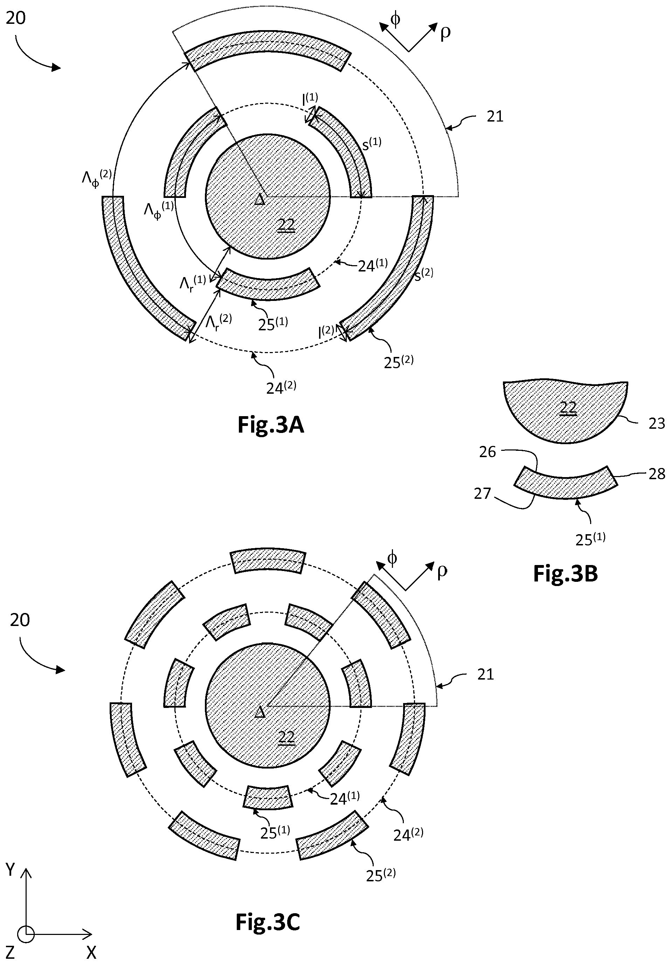

Les figures 3A et 3C sont des vues schématiques, de dessus, de deux variantes d'une lentille planaire de diffusion du dispositif d'émission 1 selon le mode de réalisation illustré sur la fig.1, la figure 3B étant une vue partielle du réseau 20 illustré sur la fig.3A.

La lentille planaire de diffusion est formée par un réseau 20 à contraste d'indice permettant de mettre en forme le faisceau lumineux généré par le VCSEL 10 pour obtenir le diagramme d'émission décrit précédemment, tout en tenant compte du fait que le faisceau lumineux généré par le VCSEL 10 est porté par les modes optiques transverses tels que le mode transverse fondamental et les modes transverses d'ordre azimutal p=1, alors que ces modes optiques transverses peuvent présenter une polarisation TE et/ou TM.

Le réseau 20 comporte une pluralité de plots 22, 25 réalisés en au moins un matériau d'un premier indice de réfraction, ici un haut indice n_{H}, et entourés par un milieu d'un deuxième indice de réfraction, ici un bas indice n_{L}, différent du premier indice. Aussi, dans cet exemple, le premier indice est supérieur au deuxième indice, mais en variante, le premier indice peut être inférieur au deuxième indice. Le milieu de bas indice n_{L} peut être formé d'un ou plusieurs matériaux, et/ou de gaz ou de vide. Le ou les matériaux de haut indice n_{H} formant les plots et le milieu de bas indice n_{L} entourant ces derniers peuvent être choisis de sorte que le contraste d'indice soit relativement faible, par exemple inférieur ou égal à 1 environ, voire à 0,5 environ, limitant ainsi les pertes optiques lors de la transmission du faisceau lumineux généré par le VCSEL 10. Ainsi, à titre d'exemple, les plots 22, 25 peuvent être réalisés en nitrure de silicium SiNₓ et être séparés les uns des autres par de l'air ou par un oxyde de silicium SiOₓ, voire être réalisés en un oxyde de silicium SiOₓ et être séparés par de l'air. D'autres matériaux de haut indice de réfraction peuvent être utilisés, comme des matériaux diélectriques tels que le CaF2 et le ZnS se présentant sous la forme d'une alternance de sous-couches.

De plus, le réseau 20 comporte un plot central 22 centré de préférence sur l'axe optique principal Δ, et une pluralité de plots périphériques 25⁽ⁱ⁾, disposés périodiquement le long d'au moins une ligne concentrique 24⁽ⁱ⁾ avec le plot central 22, et agencés de sorte que le réseau 20 présente, vis-à-vis de l'axe optique principal Δ, une symétrie de rotation d'ordre impair supérieur ou égal à trois. « i » est le rang de la ligne concentrique, avec i=1 pour la ligne concentrique la plus proche du plot central 22, et i=2, 3... pour les lignes concentriques suivantes à mesure que l'on s'éloigne du plot central 22. Une ligne concentrique 24⁽ⁱ⁾ est une ligne entourant le plot central 22 et comportant le même centre que celui du plot central 22. De préférence, une ligne concentrique 24⁽ⁱ⁾ s'étend de manière parallèle à la bordure radiale 23 du plot central 22. Par ailleurs, chaque ligne concentrique 24⁽ⁱ⁾ passe par les barycentres des sections droites des plots périphériques 25⁽ⁱ⁾ associés, dans des plans perpendiculaires au plan XY et passant par l'axe optique principal Δ.

Les plots 22, 25 sont distincts les uns des autres. Ils peuvent être reliés entre eux, ou non, par une couche mince continue d'un matériau de haut indice présentant une épaisseur inférieure à celle des plots. En d'autres termes, ils peuvent être formés à partir d'une gravure partielle ou totale d'une même couche réalisée en au moins un matériau de haut indice. Ainsi, les plots 25⁽ⁱ⁾ agencés périodiquement le long d'une même ligne concentrique 24⁽ⁱ⁾ sont distincts entre eux. Ces plots périphériques 25⁽ⁱ⁾ sont également distincts du plot central 22 d'une part, et sont distincts des plots périphériques 25⁽ⁱ⁻¹⁾, 25⁽ⁱ⁺¹⁾ agencés périodiquement le long d'une autre ligne concentrique. Ainsi, le réseau 20 présente une discrétisation du matériau de haut indice tant suivant l'axe radial p que suivant l'axe azimutal φ.

Le réseau 20 est disposé sur la surface d'émission 14, et est situé dans l'ouverture électrique 17 délimitée par le contact électrique supérieur 16. Les plots 22, 25 peuvent ainsi être directement au contact d'une couche semiconductrice quart d'onde du miroir de Bragg supérieur 13, ou être en contact d'une couche intercalaire réalisée en un matériau différent que ceux du miroir supérieur 13.

Le plot central 22 est de préférence centré sur l'axe optique principal Δ, et est disposé à la perpendiculaire de l'ouverture optique 19, de préférence au centre de l'ouverture électrique 17. Il présente une dimension suivant l'axe Z, ou épaisseur, sensiblement constante, laquelle est de préférence égale à un multiple impair de λₑ/(4.n_{H}) pour présenter une fonction optique d'antireflet. Il présente une section droite, dans le plan XY, de forme circulaire comme illustré sur les fig.3A et 3B, mais d'autres formes sont possibles, telles qu'une forme carrée ou polygonale. La forme du plot central 22 dans le plan XY dépend notamment de celle de l'ouverture optique 19 et de la forme du mesa du VCSEL 10. Le plot central 22 est de préférence circulaire lorsque l'ouverture optique 19 est circulaire et que la forme en mesa du VCSEL 10 est circulaire. Il peut être carré lorsque c'est le cas également de l'ouverture optique 19 et de la forme du mesa du VCSEL 10. La dimension de la section droite, ici le diamètre, est de préférence supérieure ou égale à la moitié de celle de l'ouverture optique 19. Ainsi, pour une ouverture optique 19 de diamètre égale à 6µm environ, le plot central 22 peut présenter un diamètre compris entre 2,5µm et 3,5µm environ. Ainsi, le plot central 22 présente un effet prépondérant dans la diffusion du faisceau lumineux transmis par le réseau 20 pour obtenir le diagramme d'émission désiré.

Les plots périphériques 25⁽ⁱ⁾ sont agencés périodiquement le long d'une ou plusieurs lignes concentriques 24⁽ⁱ⁾. Sur les fig.3A et 3B, le réseau 20 comporte deux lignes concentriques 24⁽¹⁾, 24⁽²⁾ distinctes l'une de l'autre qui s'étendent autour du plot central 22. Cependant, le réseau 20 peut ne comporter qu'une seule ligne concentrique, ou davantage de lignes concentriques. Les lignes concentriques 24⁽ⁱ⁾ peuvent s'étendre longitudinalement autour du plot central 22 de manière circulaire, polygonale, par ex. carrée, en fonction de la forme du plot central 22. Ainsi, elles peuvent s'étendre de manière circulaire ou carrée lorsque la forme du plot central 22 dans le plan XY est, respectivement, circulaire ou carrée.

Chaque plot périphérique 25⁽ⁱ⁾ présente une dimension azimutale s⁽ⁱ⁾, ou longueur, et une dimension radiale l⁽ⁱ⁾, ou largeur. La longueur s⁽ⁱ⁾ est définie comme étant la distance séparant les bordures azimutales 28 l'une de l'autre, mesurée le long de la ligne concentrique 24⁽ⁱ⁾. La largeur l⁽ⁱ⁾ est définie comme étant la distance séparant les bordures radiales interne 26 et externe 27. De préférence, la longueur s⁽ⁱ⁾ est supérieure à la largeur l⁽ⁱ⁾, de sorte que l'axe longitudinal de chaque plot périphérique 25⁽ⁱ⁾ soit orienté suivant le long de la ligne concentrique correspondante 24⁽ⁱ⁾. De plus, les plots périphériques 25⁽ⁱ⁾ étant ici des arcs de cercle s'étendant autour du plot central 22 de forme circulaire, la longueur s⁽ⁱ⁾ est alors une longueur curviligne.

Par ailleurs, chaque plot périphérique 25⁽ⁱ⁾ présente une épaisseur de préférence identique pour tous les plots 22, 25⁽ⁱ⁾, et de préférence identique à celle du plot central 22. L'épaisseur des plots périphériques 25⁽ⁱ⁾ est de préférence égale à un multiple impair de λₑ/4.n_{H} pour assurer une fonction optique d'antireflet. Ainsi, le réseau 20 forme une lentille planaire de diffusion, dans le sens où il est formé d'une pluralité de plots 22, 25⁽ⁱ⁾ distincts dont l'épaisseur est de préférence identique pour tous les plots, et se distingue ainsi des lentilles de type plan-convexe mentionnées précédemment. Ainsi, par le fait que le réseau 20 présente une épaisseur locale égale à un multiple impair λₑ/4.n_{H}, il n'induit pas de perturbation de la réflectivité locale du miroir supérieur 13. Autrement dit, la réflectivité locale associée à un réflecteur équivalent formé du miroir supérieur 13 et du réseau 20 est sensiblement égale à celle du miroir supérieur 13, et reste spatialement homogène. Il en résulte que le réseau 20 n'influe donc pas ou peu sur les modes transverses présents dans la cavité optique. Aussi, les modes transverses sont sensiblement tous transmis hors de la cavité optique, ce qui est particulièrement recherché dans le cadre des applications LiDAR ou de détection 3D, entre autres.

Les plots périphériques 25⁽ⁱ⁾ sont agencés de sorte que le réseau 20 présente une symétrie de rotation d'un ordre n impair supérieur ou égal à trois autour de l'axe optique principal Δ. Ainsi, le réseau 20 est formé de plusieurs motifs élémentaires 21, formés par les plots 25⁽ⁱ⁾ et les espacements entre les plots 25⁽ⁱ⁾, qui sont identiques les uns aux autres après une rotation autour de l'axe optique principal Δ d'un angle égal à 360°/n. L'ordre n est supérieur ou égal à trois, et est de préférence égal à cinq ou à sept, voire à davantage.

Ainsi, la fig.3A illustre un exemple de réseau 20 dont les plots périphériques 25⁽ⁱ⁾ sont agencés périodiquement le long de deux lignes concentriques 24⁽¹⁾, 24⁽²⁾ de sorte que le réseau 20 présente une symétrie de rotation d'ordre trois autour de l'axe optique principal Δ. Le réseau 20 comporte donc trois motifs élémentaires 21 distincts les uns des autres, et symétriques par rotation d'un angle de 360°/3=120° environ autour de l'axe optique principal Δ.

Par ailleurs, la fig.3B illustre un autre exemple de réseau 20 dont les plots périphériques sont agencés périodiquement le long de deux lignes concentriques 24⁽¹⁾, 24⁽²⁾ de sorte que le réseau 20 présente une symétrie de rotation d'ordre sept autour de l'axe optique principal Δ. Le réseau 20 comporte donc sept motifs élémentaires 21 distincts les uns des autres, et symétriques par rotation d'un angle de 360°/7=51° environ autour de l'axe optique principal Δ.

Ainsi, par le fait que le réseau 20 est, d'une part, discret suivant l'axe radial p comme suivant l'axe azimutal φ, et d'autre part, symétrique de rotation d'ordre impair au moins égal à trois par rapport à l'axe optique principal Δ, le dispositif d'émission 1 présente un diagramme d'émission dont la répartition angulaire du faisceau lumineux est sensiblement homogène. L'astigmatisme du faisceau lumineux est alors particulièrement réduit voire quasi absent. La répartition angulaire du faisceau lumineux est d'autant plus homogène que l'ordre impair de la symétrie de rotation du réseau 20 est élevé, par exemple égal à cinq, voire à sept, ou même davantage. En effet, par cette structuration du réseau 20 et agencement des plots 22, 25 de haut indice, on homogénéise la répartition angulaire de l'indice effectif associé aux différents modes optiques transverses du faisceau lumineux généré par le VCSEL 10, à savoir le mode transverse fondamental tout comme les modes transverses (0,1), (1,1) et (2,1) d'ordre azimutal p=1, ceci indépendamment de l'état de polarisation TE et/ou TM de ces modes transverses. Cette homogénéisation de la répartition angulaire de l'indice effectif contribue à rendre sensiblement homogène la répartition angulaire du diagramme d'émission, et notamment à rendre sensiblement homogène la symétrie de révolution du diagramme d'émission, en particulier lorsque le réseau 20, l'ouverture optique 19 et la forme du mesa du VCSEL sont circulaires, et ainsi à limiter la présence d'astigmatisme du faisceau lumineux émis par le dispositif d'émission 1.

D'une manière générale, l'indice effectif n_{eff} d'un mode optique transverse de longueur d'onde λₑ du VCSEL est défini comme le produit de la constante de propagation β et de λₑ/2π. La constante de propagation β dépend de la longueur d'onde λₑ du mode optique, ainsi que des propriétés optogéométriques du VCSEL. L'indice effectif du mode optique transverse correspond, d'une certaine manière, à l'indice de réfraction du guidé d'onde 'vu' par le mode optique.

De plus, il est avantageux que, lorsque le réseau 20 comporte plusieurs lignes concentriques 24⁽ⁱ⁾, 24⁽ⁱ⁺¹⁾, les plots périphériques 25⁽ⁱ⁾, 25⁽ⁱ⁺¹⁾ de deux lignes concentriques adjacentes soient agencés périodiquement de sorte que les plots périphériques 25⁽ⁱ⁾ d'une ligne concentrique 24⁽ⁱ⁾ présentent un décalage azimutal vis-à-vis des plots périphériques 25⁽ⁱ⁺¹⁾ de l'autre ligne concentrique 24⁽ⁱ⁺¹⁾, et de préférence, comme illustré sur les fig.3A et 3B, soient disposés en opposition de phase. Cela se traduit par le fait qu'un axe radial p⁽ⁱ⁺¹⁾ passant par le barycentre d'un plot périphérique 25⁽ⁱ⁺¹⁾ de rang i+1 n'est colinéaire avec aucun axe radial p⁽ⁱ⁾ passant par le barycentre d'un plot périphérique 25⁽ⁱ⁾ de rang i. Dans le cas où les plots périphériques 25⁽ⁱ⁾, 2,5⁽ⁱ⁺¹⁾ sont agencés en opposition de phase, cela se traduit par le fait qu'un axe radial p⁽ⁱ⁺¹⁾ forme un même angle avec les axes radiaux p⁽ⁱ⁾ de deux plots périphériques de rang i adjacents. Cet agencement relatif des plots périphériques de différentes lignes concentriques tend également à homogénéiser la répartition angulaire de l'indice effectif associé aux différents modes transverses (0,0), (0,1), (1,1) et (2,1), et ainsi à rendre sensiblement homogène la répartition angulaire du diagramme d'émission. La présence de l'aberration optique d'astigmatisme du diagramme d'émission est par ailleurs réduite voire empêchée.

Par ailleurs, on définit des périodes radiale Λ_{ρ}⁽ⁱ⁾ et azimutale Λφ⁽ⁱ⁾ associées aux plots périphériques 25⁽ⁱ⁾. La période radiale Λ_{ρ}⁽¹⁾ associée à la première ligne concentrique 24⁽¹⁾ est définie comme étant la distance séparant radialement la bordure radiale 23 du plot central 22 vis-à-vis de la bordure radiale externe 27 d'un premier plot périphérique 25⁽¹⁾. Chaque plot périphérique 25⁽ⁱ⁾ est délimité radialement par une bordure radiale interne 26 orientée vers le plot central 22, et par une bordure radiale externe 27 opposée à la bordure 26. De plus, la période radiale Λ_{ρ}⁽²⁾ associée à la deuxième ligne concentrique 24⁽²⁾ est définie comme étant la distance séparant radialement la bordure radiale externe 27 d'un plot périphérique 25⁽¹⁾ d'une ligne concentrique de rang 1 vis-à-vis de la bordure radiale externe 27 d'un plot périphérique 25⁽²⁾ d'une ligne concentrique de rang 2. Par ailleurs, la période azimutale Λ_{φ}⁽ⁱ⁾ associée à une ligne concentrique 24⁽ⁱ⁾ de rang i est définie comme étant la longueur d'un motif se répétant périodiquement le long de la ligne concentrique 24⁽ⁱ⁾, ce motif étant formé d'un plot périphérique 25⁽ⁱ⁾ et de l'espacement le séparant d'un plot périphérique 25⁽ⁱ⁾ adjacent.

Les périodes radiale Λ_{ρ}⁽ⁱ⁾ et azimutale Λ_{φ}⁽ⁱ⁾ sont de préférence supérieures ou égales à λₑ/n_{eff}', où λₑ est la longueur d'onde du faisceau lumineux émis par le dispositif d'émission 1, et n_{eff}' est ici un indice effectif d'un mode longitudinal guidé, de longueur d'onde λₑ, se propageant dans le plan du réseau 20. En première approximation, l'indice effectif n_{eff}' peut être égal à la moyenne du haut indice n_{H} et du bas indice n_{L} de réfraction. Ainsi, le réseau 20 présente une transmission élevée à la longueur d'onde d'émission λₑ, de sorte que la transmission hors du VCSEL n'est sensiblement pas dégradée du fait de la présence du réseau 20. En effet, comme le montre la publication de Chang-Hasnain et Yang intitulée High-contrast gratings for integrated optoelectronics, Adv. Opt. Photonics 4, 379-440 (2012), dans le cas d'une onde incidente de longueur d'onde λ_{c} se propageant vers un réseau 20 à contraste d'indice formé de bandes rectilignes de haut indice de réfraction agencées parallèlement avec une période Λ, le réseau 20 présente un régime diffractif lorsque le rapport λₑ/Λ est inférieure à 1 environ, moyennant l'indice effectif du mode guidé, se traduisant par une forte diminution de la réflectivité du réseau 20 à la longueur d'onde d'émission λₑ, et en conséquence, d'une augmentation de la transmission de l'onde incidente par le réseau 20.

Ainsi, la période radiale Λ_{ρ}⁽ⁱ⁾ associée à une ligne concentrique 24⁽ⁱ⁾ de rang i est supérieure ou égale à λₑ/n_{eff}'. De préférence, la période Λ_{ρ}⁽ⁱ⁺¹⁾ d'une ligne concentrique 24⁽ⁱ⁺¹⁾ de rang i+1 est supérieure ou égale à la période Λ_{ρ}⁽ⁱ⁾ de la ligne concentrique 24⁽ⁱ⁾ de rang i. A titre d'exemple, dans le cas d'un dispositif d'émission 1 émettant à une longueur d'onde λₑ égale à 940nm environ, la période radiale Λ_{ρ}⁽¹⁾ peut être égale à 1µm environ, et la période radiale Λ_{ρ}⁽²⁾ peut être égale à 1,25µm environ.

Par ailleurs, la période azimutale Λ_{φ}⁽ⁱ⁾ associée à une ligne concentrique 24⁽ⁱ⁾ de rang i est supérieure ou égale à λₑ/n_{eff}'. Elle est de préférence supérieure ou égale à la période radiale Λ_{ρ}⁽ⁱ⁾. De préférence, la période azimutale Λ_{φ}⁽ⁱ⁺¹⁾ d'une ligne concentrique 24⁽ⁱ⁺¹⁾ de rang i+1 est supérieure ou égale Λ_{φ}⁽ⁱ⁾ de la ligne concentrique 24⁽ⁱ⁾ de rang i. A titre d'exemple, pour une longueur d'onde λₑ égale à 940nm environ, la période azimutale Λ_{φ}⁽ⁱ⁾ peut être égale à 2µm environ, et la période azimutale Λ_{φ}⁽ⁱ⁾ peut être égale à 2,5µm environ.

Par ailleurs, les plots périphériques 25⁽ⁱ⁾ sont de préférence agencés et dimensionnés de sorte que le taux de remplissage du réseau 20 diminue radialement. Le taux de remplissage est associé à une période radiale Λ_{ρ}⁽ⁱ⁾ donnée, et correspond à la moyenne azimutale pour φ allant de 0° à 360° de l'indice de réfraction, pour une zone associée à la période radiale Λ_{ρ}⁽ⁱ⁾ considérée. A titre illustratif, le taux de remplissage associé à la période radiale Λ_{ρ}⁽¹⁾ est la moyenne de l'indice de réfraction du réseau 20 pour une zone annulaire délimitée radialement par la bordure radiale 23 du plot central 22 et la bordure radiale externe 27 des plots périphériques 25⁽¹⁾ de la ligne concentrique de rang 1. Le taux de remplissage est alors maximal au niveau du plot central 22, puis diminue pour la période radiale Λρ⁽¹⁾ et diminue encore pour la période radiale Λ_{ρ}⁽²⁾. La diminution radiale du taux de remplissage contribue à transmettre de façon contrôlée le faisceau lumineux dans le diagramme d'émission désiré.

A titre d'exemple, le dispositif d'émission 1 peut comporter au moins un VCSEL 10 dont la cavité résonante 11 est délimitée par deux miroirs de Bragg 12, 13 réalisés en une alternance de couches semiconductrices quart d'onde en GaAs et en AlGaAs. Le milieu à gain 15 comporte des puits quantiques réalisés en InGaAs, et le VCSEL 10 est ici adapté à générer un faisceau lumineux dont la longueur d'onde λₑ est centrée sur 940nm. L'ouverture optique 19 est formée par un diaphragme d'oxyde d'aluminium situé entre le milieu à gain 15 et le miroir supérieur 13. L'ouverture optique 19 présente ici une forme circulaire d'un diamètre égal à 6µm environ. Un contact électrique 16, réalisé à base d'or, repose sur la face supérieure du miroir de Bragg 13, et présente une forme circulaire de manière à définir l'ouverture électrique 17 dans laquelle est située la surface d'émission 14 du VCSEL 10.

Le réseau 20 à contraste d'indice est situé dans l'ouverture électrique 17 et repose sur la surface d'émission 14. Il est formé de plusieurs plots 22, 25 distincts réalisés en nitrure de silicium, et séparés latéralement les uns des autres par de l'air. Le réseau 20 comporte un plot central 22 centré sur l'axe optique principal Δ, de forme circulaire et de diamètre égal à la moitié environ de celui de l'ouverture optique 19, ici égal à 3µm environ. Le réseau 20 comporte des plots périphériques 25⁽¹⁾, 25⁽²⁾ qui s'étendent périodiquement le long de deux lignes concentriques 24⁽¹⁾, 24⁽²⁾ vis-à-vis du plot central 22. Les lignes concentriques 24⁽¹⁾, 24⁽²⁾ présentent une forme circulaire et les plots périphériques 25⁽¹⁾, 25⁽²⁾ une forme d'arc de cercle. Les plots périphériques 25⁽¹⁾, 25⁽²⁾ sont agencés de sorte que le réseau 20 présente ici, vis-à-vis de l'axe optique principal Δ, une symétrie de rotation d'ordre 7.

Ainsi, le réseau 20 comporte une ligne concentrique 24⁽¹⁾ de rang 1 suivant laquelle sont ici agencés sept plots périphériques 25⁽¹⁾ avec une période azimutale Λ_{φ}⁽¹⁾ égale ici 2µm environ. Les plots périphériques 25⁽¹⁾ présentent une longueur curviligne s⁽¹⁾ égale à 1µm environ et sont espacés deux à deux d'une distance curviligne de 1µm environ. Ils présentent une largeur l⁽¹⁾ égale à 500nm environ et la période radiale Λ_{ρ}⁽¹⁾ est égale à 1µm environ. Ainsi, la bordure radiale interne 26 des plots périphériques 25⁽¹⁾ est espacée de la bordure radiale 23 du plot central 22 d'une distance de 500nm environ.

De plus, le réseau 20 comporte une ligne concentrique 24⁽²⁾ de rang 2 suivant laquelle sont ici agencés sept plots périphériques 25⁽²⁾ avec une période azimutale Λ_{φ}⁽²⁾ égale ici 2,5µm environ. Les plots périphériques 25⁽²⁾ présentent une longueur curviligne s⁽²⁾ égale à 750nm environ et présentent une largeur l⁽²⁾ égale à 500nm environ pour une période radiale Λ_{ρ}⁽²⁾ égale à 1,25µm environ. Ainsi, la bordure radiale interne 26 des plots périphériques 25⁽²⁾ est espacée de la bordure radiale externe 27 des plots périphériques 25⁽¹⁾ d'une distance de 750nm environ. De plus, les plots périphériques 25⁽²⁾ de la ligne concentrique 24⁽²⁾ de rang 2 sont agencés de manière à présenter un décalage azimutal avec les plots périphériques 25⁽¹⁾ de la ligne concentrique 24⁽¹⁾ de rang 1, et plus précisément une opposition de phase avec ces derniers.

Ainsi, par le fait que le réseau 20 présente une symétrie de rotation d'ordre impair supérieur ou égal à trois, ici égal à sept, le réseau 20 permet de transmettre efficacement le mode transverse fondamental ainsi que les modes transverses d'ordre azimutal p=1 et d'obtenir un diagramme d'émission désiré ne présentant sensiblement pas d'astigmatisme, quel que soit l'état de polarisation TE et/ou TM des modes optiques transverses. Le diagramme d'émission présente alors une symétrie de rotation sensiblement homogène. De plus, l'agencement en opposition de phase des plots périphériques 25⁽²⁾ de rang 2 par rapport à ceux 25⁽¹⁾ de rang 1 permet d'améliorer la répartition angulaire de l'indice effectif autour de l'axe optique principal Δ et donc participe à homogénéiser la répartition angulaire du diagramme d'émission, voire à limiter la présence d'une aberration optique telle que l'astigmatisme. Par ailleurs, dans la mesure où les périodes radiales et azimutales sont supérieures ou égales à λₑ/n_{eff}', le réseau 20 de transmission présente une bonne transmission à la longueur d'onde d'émission λₑ.

Des études par simulation numérique réalisées au moyen du logiciel RSoft - FullWave, développé et distribué par la société Synopsys, ont permis de comparer le comportement optique d'un VCSEL 10 associé à la lentille de diffusion telle que décrite précédemment, avec un VCSEL 10 ne comportant pas cette même lentille de diffusion. Il en ressort que le diagramme d'émission du dispositif d'émission 1 comportant le réseau 20 présente un diagramme d'émission à symétrie de révolution sensiblement homogène et un angle de diffusion à mi-hauteur égal à 20° environ, alors que ce même angle est égal à 10° environ sans le réseau 20. Le dispositif d'émission 1 selon le mode de réalisation permet ainsi d'obtenir le diagramme d'émission voulu. Par ailleurs, la longueur d'onde λₑ du faisceau lumineux généré n'est pas modifiée par la présence du réseau 20, dans la mesure où elle est de 941,6nm pour le dispositif d'émission 1 avec le réseau 20, et de 941,3nm lorsque le réseau 20 est absent. De plus, le facteur de qualité est de 1500 pour le dispositif d'émission 1 avec le réseau 20, alors qu'il est de 1300 sans le réseau 20. Aussi, la présence d'un tel réseau 20 formant une lentille de diffusion ne modifie pas la longueur d'onde d'émission λₑ et participe en outre à réduire les pertes optiques associées à la transmission du faisceau lumineux généré par le VCSEL 10.

Le dispositif d'émission lumineuse 1 peut comporter une matrice de VCSEL 10 dont chaque VCSEL 10 est revêtu par un réseau 20 à contraste d'indice formant une lentille planaire de diffusion. Le procédé de fabrication d'un tel dispositif comporte avantageusement une étape de réalisation collective des VCSEL 10, puis une étape de dépôt conforme d'une couche 3 à haut indice de réfraction sur la face supérieure du miroir de Bragg 13. Cette couche 3 de haut indice est de préférence une couche de passivation, par exemple réalisée en nitrure de silicium SiNₓ, laquelle est utilisée classiquement pour isoler électriquement les contacts électriques supérieurs 16 entre eux et pour assurer une protection du miroir supérieur 13. Le procédé de fabrication peut comporter ensuite une étape de réalisation collective des réseaux 20 associés aux VCSEL 10, au moyen des techniques classiques de la microélectronique de photolithographie et gravure localisée. Cette gravure localisée est de préférence une gravure sèche, partielle ou totale, de la couche de passivation 3.

Ainsi, le procédé de fabrication présente de meilleures performances que celles associées au procédé de l'exemple de l'art antérieur mentionné précédemment, dans la mesure où il ne comporte pas d'étape de positionnement et d'assemblage d'une matrice de microlentilles réalisée préalablement à partir d'une couche de polymère. Le procédé présente ainsi des coûts réduits et les risques de défauts d'alignement des lentilles vis-à-vis des VCSEL 10 sont diminués. De plus, dans la mesure où les périodes radiales et azimutales associées aux plots périphériques 25 sont supérieures ou égales à λₑ/n_{eff}', ici supérieures ou égales à 1µm environ, le procédé est simplifié dans la mesure où il n'est pas nécessaire de recouvrir à des techniques de gravure permettant de réaliser la gravure localisée sur des dimensions particulièrement faibles, par exemple de l'ordre de la dizaine de nanomètres. De plus, il est possible d'utiliser des matériaux dont le contraste d'indice n_{H}-n_{L} est de l'ordre de 1 voire inférieur à 1.

Des modes de réalisation particuliers viennent d'être décrits. Différentes variantes et modifications apparaîtront à l'homme du métier. Ainsi, le dispositif d'émission 1 peut comporter une pluralité de VCSEL 10 identiques mais dont les diagrammes d'émission propres sont différents. Pour cela, les réseaux 20 à contraste d'indice associés aux VCSEL 10 présentent des dimensions et/ou un agencement des plots périphériques 25 différents entre eux.

## Revendications

1. Dispositif (1) d'émission d'un faisceau lumineux, comprenant :
∘ une source laser (10) à cavité verticale émettant par la surface, comportant une cavité résonante (11), s'étendant suivant un axe optique principal (Δ), délimitée par deux miroirs (12, 13), dont un miroir supérieur (13) qui définit une surface d'émission (14) ;
• la cavité résonante (11) étant adaptée à supporter plusieurs modes optiques transverses, dont un mode transverse fondamental et des modes transverses d'ordre supérieur présentant une symétrie de rotation d'ordre deux autour de l'axe optique principal (Δ) ;
ledit dispositif comportant en outre :
∘ un réseau (20) à contraste d'indice, formant une lentille de diffusion, disposé sur la surface d'émission (14), et comportant une pluralité de plots (22, 25⁽ⁱ⁾) distincts les uns des autres et réalisés en au moins un matériau d'un premier indice de réfraction (n_{H}) entourés par un milieu d'un deuxième indice de réfraction (n_{L}) différent du premier indice, parmi lesquels :
• un plot central (22), centré sur l'axe optique principal (Δ),
ledit dispositif (1) étant **caractérisé en ce que** ledit réseau (20) comporte en outre :
• plusieurs plots périphériques (25⁽ⁱ⁾), disposés périodiquement le long d'une ou plusieurs lignes concentriques (24⁽ⁱ⁾) vis-à-vis du plot central (22), et agencés de sorte que le réseau (20) présente, vis-à-vis de l'axe optique principal (Δ), une symétrie de rotation d'ordre impair supérieur ou égal à trois.

2. Dispositif d'émission (1) selon la revendication 1, dans lequel, pour une ligne concentrique (24⁽¹⁾) dite de rang 1 disposée en regard du plot central (22), une période radiale (Λ_{ρ}⁽¹⁾) est définie comme étant une distance suivant un axe radial (p) entre une bordure radiale externe (27) d'un plot périphérique (25⁽¹⁾) vis-à-vis d'une bordure radiale (23) du plot central (22), et une période azimutale (Λ_{φ}⁽¹⁾) est définie comme étant la période de l'agencement périodique des plots périphériques (25⁽¹⁾) suivant ladite ligne concentrique (24⁽¹⁾) de rang 1, la période radiale (Λ_{ρ}⁽¹⁾) et la période azimutale (Λ_{φ}⁽¹⁾) étant supérieures ou égales à λₑ/n_{eff}', où λₑ est la longueur d'onde du faisceau lumineux généré par la source laser (10) et n_{eff}' est un indice effectif d'un mode longitudinal de longueur d'onde λₑ et guidé par le réseau (20).

3. Dispositif d'émission (1) selon la revendication 2, comportant une ligne concentrique (24⁽²⁾) dite de rang 2 disposée de manière à entourer la ligne concentrique (24⁽¹⁾) de rang 1, pour laquelle une période radiale (Λ_{ρ}⁽²⁾) est définie comme étant une distance suivant un axe radial (p) entre une bordure radiale externe (27) d'un plot périphérique (25⁽²⁾) de la ligne concentrique (24⁽²⁾) de rang 2 vis-à-vis d'une bordure radiale externe (27) d'un plot périphérique (25⁽¹⁾) de la ligne concentrique (24⁽¹⁾) de rang 1, et une période azimutale (Λ_{φ}⁽²⁾) est définie comme étant la période de l'agencement périodique des plots périphériques (25⁽²⁾) suivant ladite ligne concentrique (24⁽²⁾) de rang 2, les périodes radiale (Λ_{ρ}⁽²⁾) et azimutale (Λ_{φ}⁽²⁾) associées à la ligne concentrique (24⁽²⁾) de rang 2 étant respectivement supérieures ou égales aux périodes radiale (Λ_{ρ}⁽¹⁾) et azimutale (Λ_{φ}⁽¹⁾) associées à la ligne concentrique (24⁽¹⁾) de rang 1.

4. Dispositif d'émission (1) selon la revendication 2 ou 3, les périodes radiale (Λ_{ρ}⁽ⁱ⁾) et azimutale (Λ_{φ}⁽¹⁾) associées à une ligne concentrique (24⁽ⁱ⁾) de rang i sont supérieures ou égales à la longueur d'onde λₑ.

5. Dispositif d'émission (1) selon l'une quelconque des revendications 1 à 4, dans lequel le réseau (20) comporte au moins deux lignes concentriques (24⁽¹⁾), 24⁽²⁾) dites de rang 1 et 2, les plots périphériques (25⁽²⁾) de la ligne concentrique (24⁽²⁾) de rang 2 étant agencés de manière à présenter un décalage azimutal avec les plots périphériques (25⁽¹⁾) de la ligne concentrique (24⁽¹⁾) de rang 1.

6. Dispositif d'émission (1) selon la revendication 5, dans lequel les plots périphériques (25⁽²⁾) de la ligne concentrique (24⁽²⁾) de rang 2 étant agencés en opposition de phase avec les plots périphériques (25⁽¹⁾) de la ligne concentrique (24⁽¹⁾) de rang 1.

7. Dispositif d'émission (1) selon l'une quelconque des revendications 1 à 6, dans lequel la cavité résonante (11) comporte un diaphragme (18) définissant une ouverture optique (19) dont une dimension latérale est supérieure ou égale à la longueur d'onde λₑ du faisceau lumineux généré par la source laser (10).

8. Dispositif d'émission (1) selon la revendication 7, dans lequel le plot central (22) présentant une dimension latérale supérieure ou égale à la moitié, à 10% près, d'une dimension latérale de l'ouverture optique (19).

9. Dispositif d'émission (1) selon la revendication 7 ou 8, dans lequel le plot central (22) et l'ouverture optique (19) présentent une forme circulaire.

10. Dispositif d'émission (1) selon l'une quelconque des revendications 1 à 9, dans lequel le contraste d'indice entre le premier indice de réfraction (n_{H}) et le deuxième indice de réfraction (n_{L}) est inférieur ou égal à 1.

11. Dispositif d'émission (1) selon l'une quelconque des revendications 1 à 10, dans lequel les plots (22, 25⁽ⁱ⁾) présentent une épaisseur égale à un multiple impair de λₑ/(4.n_{H}), où λₑ est la longueur d'onde du faisceau lumineux généré par la source laser (10) et n_{H} est l'indice de réfraction des plots (22, 25⁽ⁱ⁾).

12. Procédé de fabrication du dispositif d'émission (1) selon l'une quelconque des revendications précédentes, comportant une étape de réalisation collective d'une matrice de sources laser (10) identiques entre elles, une étape de dépôt conforme d'une couche de passivation (3) sur la surface d'émission (14) des sources laser (10), puis une étape de réalisation collective des réseaux (20) à contraste d'indice par gravure localisée de la couche de passivation (3).

## Patentansprüche

1. Vorrichtung (1) zur Emission eines Lichtbündels, umfassend:
o eine Oberflächenemitter-Laserquelle (10) mit vertikaler Kavität, aufweisend eine resonante Kavität (11), die sich entlang einer optischen Hauptachse (Δ) erstreckt, die von zwei Spiegeln (12, 13) begrenzt ist, wovon einer ein oberer Spiegel (13) ist, der eine Emissionsfläche (14) definiert;
. wobei die resonante Kavität (11) geeignet ist, mehrere optische Quermoden zu unterstützen, davon eine Grund-Quermode und Quermoden höherer Ordnung mit einer Drehsymmetrie zweiter Ordnung um die optische Hauptachse (Δ);
wobei die Vorrichtung ferner Folgendes aufweist:
o ein Indexkontrastnetzwerk (20), das eine Streulinse bildet, das auf der Emissionsfläche (14) angeordnet ist und eine Mehrzahl von Feldern (22, 25⁽ⁱ⁾) aufweist, die voneinander gesondert sind und aus mindestens einem Material mit einem ersten Brechungsindex (n_{H}) hergestellt sind, die von einem Milieu mit einem zweiten Brechungsindex (n_{L}) umgeben sind, der sich vom ersten Index unterscheidet, davon:
• ein Mittelfeld (22), das auf der optischen Hauptachse (Δ) zentriert ist,
wobei die Vorrichtung (1) **dadurch gekennzeichnet ist, dass** das Netzwerk (20) ferner Folgendes aufweist:
• mehrere Randfelder (25⁽ⁱ⁾), die periodisch entlang einer oder mehrerer Linien (24⁽ⁱ⁾) angeordnet sind, die konzentrisch zum Mittelfeld (22) verlaufen, und so angeordnet sind, dass das Netzwerk (20) zur optischen Hauptachse (Δ) eine Drehsymmetrie ungerader Ordnung größer als oder gleich drei aufweist.

2. Emissionsvorrichtung (1) nach Anspruch 1, wobei für eine konzentrische Linie (24⁽¹⁾) 1. Ranges, die gegenüber dem Mittelfeld (22) angeordnet ist, eine radiale Periode (Λ_{ρ}⁽¹⁾) als ein Abstand entlang einer radialen Achse (p) zwischen einer radialen Außenkante (27) eines Randfelds (25⁽¹⁾) zu einer radialen Kante (23) des Mittelfelds (22) definiert ist und eine azimutale Periode (Λ_{ϕ}⁽¹⁾) als die Periode der periodischen Anordnung der Randfelder (25⁽¹⁾) entlang der konzentrischen Linie (24⁽¹⁾) 1. Ranges definiert ist, wobei die radiale Periode (Λ_{ρ}⁽¹⁾) und die azimutale Periode (Λ_{ϕ}⁽¹⁾) größer als oder gleich λₑ/n_{eff}' sind, wobei λₑ die Wellenlänge des Lichtbündels ist, das von der Laserquelle (10) erzeugt wird, und n_{eff}' ein effektiver Index einer Längsmode ist, die die Wellenlänge λₑ aufweist und vom Netzwerk (20) geleitet wird.

3. Emissionsvorrichtung (1) nach Anspruch 2, aufweisend eine konzentrische Linie (24⁽²⁾) 2. Ranges, die so angeordnet ist, dass sie die konzentrische Linie (24⁽¹⁾) 1. Ranges umgibt, für die eine radiale Periode (Λ_{ρ}⁽²⁾) als ein Abstand entlang einer radialen Achse (p) zwischen einer radialen Außenkante (27) eines Randfeldes (25⁽²⁾) der konzentrischen Linie (24⁽²⁾) 2. Ranges zu einer radialen Außenkante (27) eines Randfeldes (25⁽¹⁾) der konzentrischen Linie (24⁽¹⁾) 1. Ranges definiert ist, und eine azimutale Periode (Λ_{ϕ}⁽²⁾) als die Periode der periodischen Anordnung der Randfelder (25⁽²⁾) entlang der konzentrischen Linie (24⁽²⁾) 2. Ranges definiert ist, wobei die radiale (Λ_{ρ}⁽²⁾) und azimutale (Λ_{ϕ}⁽²⁾) Periode, die der konzentrischen Linie (24⁽²⁾) 2. Ranges zugeordnet sind, jeweils größer als oder gleich der radialen (Λρ⁽¹⁾) und azimutalen (Λ_{ϕ}⁽¹⁾) Periode sind, die der konzentrischen Linie (24⁽¹⁾) 1. Ranges zugeordnet sind.

4. Emissionsvorrichtung (1) nach Anspruch 2 oder 3, wobei die radiale (Λ_{ρ}⁽ⁱ⁾) und azimutale (Λ_{ϕ}⁽ⁱ⁾) Periode, die einer konzentrischen Linie (24⁽ⁱ⁾) i-ten Ranges zugeordnet sind, größer als oder gleich der Wellenlänge λₑ sind.

5. Emissionsvorrichtung (1) nach einem der Ansprüche 1 bis 4, wobei das Netzwerk (20) mindestens zwei konzentrische Linien (24⁽¹⁾, 24⁽²⁾) 1. und 2. Ranges aufweist, wobei die Randfelder (25⁽²⁾) der konzentrischen Linie (24⁽²⁾) 2. Ranges so angeordnet sind, dass sie einen azimutalen Versatz zu den Randfeldern (25⁽¹⁾) der konzentrischen Linie (24⁽¹⁾) 1. Ranges aufweisen.

6. Emissionsvorrichtung (1) nach Anspruch 5, wobei die Randfelder (25⁽²⁾) der konzentrischen Linie (24⁽²⁾) 2. Ranges gegenphasig zu den Randfeldern (25⁽¹⁾) der konzentrischen Linie (24⁽¹⁾) 1. Ranges angeordnet sind.

7. Emissionsvorrichtung (1) nach einem der Ansprüche 1 bis 6, wobei die resonante Kavität (11) ein Diaphragma (18) aufweist, das eine optische Öffnung (19) definiert, deren eine Seitenabmessung größer als oder gleich der Wellenlänge λₑ des Lichtbündels ist, das von der Laserquelle (10) erzeugt wird.

8. Emissionsvorrichtung (1) nach Anspruch 7, wobei das Mittelfeld (22) eine Seitenabmessung aufweist, die bis auf 10 % größer als oder gleich der Hälfte einer Seitenabmessung der optischen Öffnung (19) ist.

9. Emissionsvorrichtung (1) nach Anspruch 7 oder 8, wobei das Mittelfeld (22) und die optische Öffnung (19) eine Kreisform aufweisen.

10. Emissionsvorrichtung (1) nach einem der Ansprüche 1 bis 9, wobei der Indexkontrast zwischen dem ersten Brechungsindex (n_{H}) und dem zweiten Brechungsindex (n_{L}) kleiner als oder gleich 1 ist.

11. Emissionsvorrichtung (1) nach einem der Ansprüche 1 bis 10, wobei die Felder (22, 25⁽ⁱ⁾) eine Dicke aufweisen, die gleich einem ungeraden Vielfachen von λₑ/(4.n_{H}) ist, wobei λₑ die Wellenlänge des Lichtbündels ist, das von der Laserquelle (10) erzeugt wird, und n_{H} der Brechungsindex der Felder (22, 25⁽ⁱ⁾) ist.

12. Verfahren zur Fertigung der Emissionsvorrichtung (1) nach einem der vorhergehenden Ansprüche, aufweisend einen Schritt des gemeinsamen Herstellens einer Matrix aus Laserquellen (10), die zueinander identisch sind, einen Schritt des Aufbringens einer Passivierungsschicht (3) auf der Emissionsfläche (14) der Laserquellen (10), dann einen Schritt des gemeinsamen Herstellens der Indexkontrastnetzwerke (20) durch lokalisiertes Ätzen der Passivierungsschicht (3).

## Claims

1. Device (1) for emitting a light beam, comprising:
∘ a vertical-cavity surface-emitting laser (10) comprising a resonant cavity (11) that extends along a main optical axis (Δ) and that is bounded by two mirrors (12, 13) a top mirror (13) of which defines an emission surface (14);
• the resonant cavity (11) being adapted to support a plurality of transverse optical modes, including a fundamental transverse mode and transverse modes of higher order having a rotational symmetry of order two about the main optical axis (Δ);
said device furthermore comprising:
∘ an index-contrast grating (20) forming a diffusion lens, said grating being arranged on the emission surface (14) and comprising a plurality of pads (22, 25⁽ⁱ⁾) that are separate from one another and that are made of at least one material of a first refractive index (n_{H}), said pads being encircled by a medium of a second refractive index (n_{L}) different from the first index, said pads including:
• a central pad (22), which is centered on the main optical axis (Δ),
said device (1) being **characterized in that** said grating (20) furthermore comprises:
• a plurality of peripheral pads (25⁽ⁱ⁾), which are periodically arranged along one or more lines (24⁽ⁱ⁾) that are concentric with respect to the central pad (22), and which are arranged so that the grating (20) has, with respect to the main optical axis (Δ), a rotational symmetry of uneven order higher than or equal to three.

2. Emitting device (1) according to Claim 1, wherein, for a concentric line (24⁽¹⁾) said to be of rank 1 arranged facing the central pad (22), a radial period (Λ_{ρ}⁽¹⁾) is defined as being a distance along a radial axis (p) between an external radial border (27) of a peripheral pad (25⁽¹⁾) with respect to a radial border (23) of the central pad (22), and an azimuthal period (Λ_{φ}⁽¹⁾) is defined as being the period of the periodic arrangement of the peripheral pads (25⁽¹⁾) along said concentric line (24⁽¹⁾) of rank 1, the radial period (Λ_{ρ}⁽¹⁾) and the azimuthal period (Λ_{φ}⁽¹⁾) being longer than or equal to λₑ/n_{eff}', where λₑ is the wavelength of the light beam generated by the laser (10) and n_{eff}' is an effective index of a longitudinal mode of wavelength λₑ and guided by the grating (20).

3. Emitting device (1) according to Claim 2, comprising a concentric line (24⁽²⁾) said to be of rank 2 arranged so as to encircle the concentric line (24⁽¹⁾) of rank 1, for which a radial period (Λ_{ρ}⁽²⁾) is defined as being a distance along a radial axis (p) between an external radial border (27) of a peripheral pad (25⁽²⁾) of the concentric line (24⁽²⁾) of rank 2 with respect to an external radial border (27) of a peripheral pad (25⁽¹⁾) of the concentric line (24⁽¹⁾) of rank 1, and an azimuthal period (Λ_{φ}⁽²⁾) is defined as being the period of the periodic arrangement of the peripheral pads (25⁽²⁾) along said concentric line (24⁽²⁾) of rank 2, the radial period (Λ_{ρ}⁽²⁾) and azimuthal period (Λ_{φ}⁽²⁾) that are associated with the concentric line (24⁽²⁾) of rank 2 being longer than or equal to the radial period (Λ_{ρ}⁽¹⁾) and azimuthal period (Λ_{φ}⁽¹⁾) that are associated with the concentric line (24⁽¹⁾) of rank 1, respectively.

4. Emitting device (1) according to Claim 2 or 3, the radial period (Λ_{ρ}⁽ⁱ⁾) and azimuthal period (Λ_{φ}⁽ⁱ⁾) that are associated with a concentric line (24⁽ⁱ⁾) of rank i being longer than or equal to the wavelength λₑ.

5. Emitting device (1) according to any one of Claims 1 to 4, wherein the grating (20) comprises at least two concentric lines (24⁽¹⁾, 24⁽²⁾) said to be of rank 1 and 2, the peripheral pads (25⁽²⁾) of the concentric line (24⁽²⁾) of rank 2 being arranged so as to have an azimuthal offset with respect to the peripheral pads (25⁽¹⁾) of the concentric line (24⁽¹⁾) of rank 1.

6. Emitting device (1) according to Claim 5, wherein the peripheral pads (25⁽²⁾) of the concentric line (24⁽²⁾) of rank 2 are arranged in phase opposition with the peripheral pads (25⁽¹⁾) of the concentric line (24⁽¹⁾) of rank 1.

7. Emitting device (1) according to any one of Claims 1 to 6, wherein the resonant cavity (11) comprises a diaphragm (18) defining an optical aperture (19) a lateral dimension of which is larger than or equal to the wavelength λₑ of the light beam generated by the laser (10).

8. Emitting device (1) according to Claim 7, wherein the central pad (22) has a lateral dimension larger than or equal to half, to within 10%, of a lateral dimension of the optical aperture (19).

9. Emitting device (1) according to Claim 7 or 8, wherein the central pad (22) and the optical aperture (19) have a circular shape.

10. Emitting device (1) according to any one of Claims 1 to 9, wherein the index contrast between the first refractive index (n_{H}) and the second refractive index (n_{L}) is smaller than or equal to 1.

11. Emitting device (1) according to any one of Claims 1 to 10, wherein the pads (22, 25⁽ⁱ⁾) have a thickness equal to an uneven multiple of λₑ/(4.n_{H}), where λₑ is the wavelength of the light beam generated by the laser (10) and n_{H} is the refractive index of the pads (22, 25⁽ⁱ⁾).

12. Process for fabricating the emitting device (1) according to any one of the preceding claims, comprising a step of wafer-scale production of a matrix array of lasers (10) that are identical to one another, a step of conformal deposition of a passivation layer (3) on the emission surface (14) of the lasers (10), then a step of wafer-scale production of the index-contrast gratings (20) by localized etching of the passivation layer (3).
